Europäisches Patentamt

European Patent Office

Office européen des brevets

(19)

(11) Veröffentlichungsnummer: **0 309 926**
**A2**

(12) **EUROPÄISCHE PATENTANMELDUNG**

(21) Anmeldenummer: **88115611.1**

(22) Anmeldetag: **22.09.88**

(51) Int. Cl.⁴: **G06F 15/60**

(30) Priorität: **29.09.87 DE 3732851**

(43) Veröffentlichungstag der Anmeldung:
**05.04.89 Patentblatt 89/14**

(84) Benannte Vertragsstaaten:
**AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Zeisler, Peter, Dipl.-Ing.**
**Keferloher Strasse 6**
**D-8000 München 40(DE)**

(54) Verfahren zur Herstellung vollparametrisierbarer Schaltungen in integrierter Schaltkreistechnik.

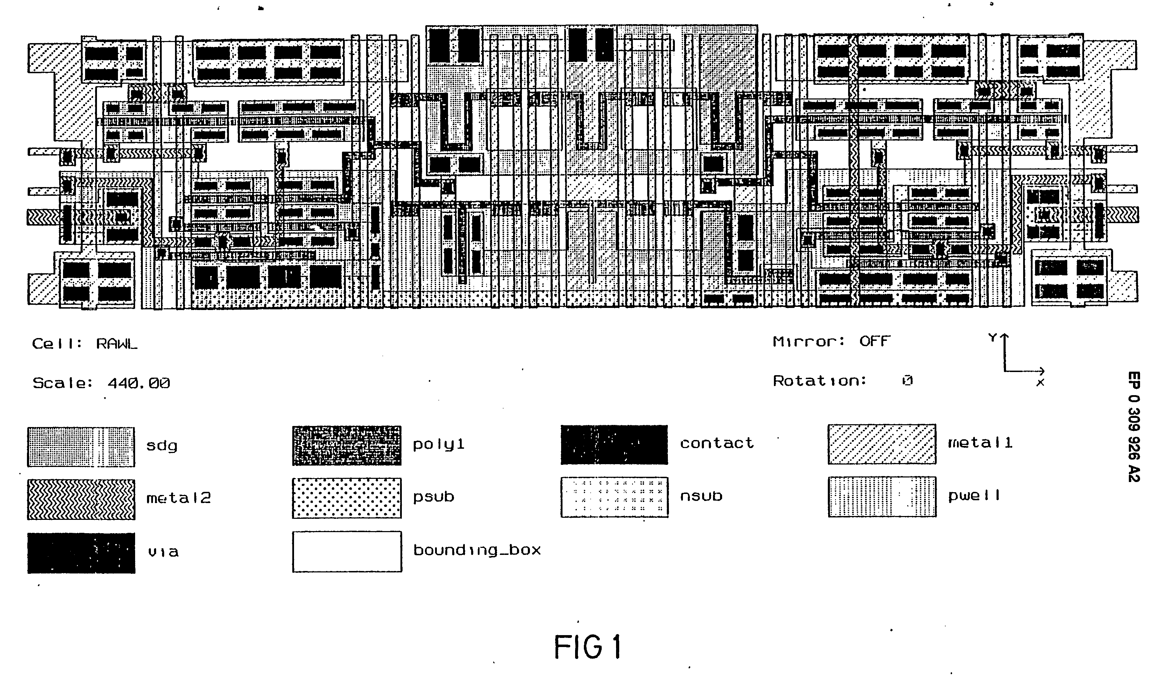

(57) Ein Verfahren zur Herstellung vollparametrisierbarer Schaltungen, bei dem in einem ersten Verfahrensschritt von einer für den ungünstigen Fall (worst case) ausgelegten Schaltung ausgegangen wird (Fig. 1), um die darin zu parametrisierenden Schaltungselemente "auszublenden", wobei die Ausgangsschaltung in Form eines Datenblocks bereitgestellt wird und die "auszublendenden" Schaltungselemente" - vertreten durch entspechende Datensätze - aus dem Datenblock herausgetrennt und zu ihrer Parametrisierung gesondert abgelegt werden, und die so erhaltene Schaltungsstruktur als Schaltungsschablone in geeigneter Weise zwischenzeitlich abgelegt wird, und in einem zweiten Verfahrensschritt die zu parametrisierenden Schaltungselemente individuell für den jeweiligen Betriebsfall in geeigneter Weise ausgelegt werden, um daran anschließend zusammen mit der Schaltungsschablone als vollparametrisierte Schaltung zusammengesetzt und als neuer Datenblock abgelegt zu werden.

FIG 1

EP 0 309 926 A2

## Verfahren zur Herstellung vollparametrisierbarer Schaltungen in integrierter Schaltkreistechnik

Die vorliegende Erfindung betrifft ein Verfahren zur Herstellung vollparametrisierbarer Schaltungen in integrierter Schaltkreistechnik.

Durch die Herstellung vollparametrisierbarer Schaltungen erhält der Schaltungsentwickler die Möglichkeit, vorab entwickelte Schaltungen individuell äußeren Belastungen oder speziellen Schaltungs-Spezifikationen anzupassen, z. B. zur Anpassung der Treiberfähigkeit an die kapazitive Belastung einer zu treibenden Leitung oder zur Änderung der Schaltungsfunktion im Hinblick auf eine gegebene Spezifikation.

Vorab entwickelte Schaltungen für den genannten Zweck werden z. B. in sog. Generatorprogrammen für den sog. ungünstigen Fall (worst case), d. h. z. B. für den maximal auftretenden Belastungsfall, ausgelegt.

Durch Anpassung der Schaltung an den jeweiligen Betriebsfall, nämlich deren Parametrisierung, kann häufig sowohl eine Verringerung der Verlustleistung und der Fläche als auch eine Erhöhung der Schaltgeschwindigkeit erreicht werden.

Derzeit bekannte Vorgehensweisen sehen die Anpassung einer betreffenden Schaltung an die äußeren Belastungen in folgender Art und Weise vor:
- Entwurf einer neuen Schaltung oder Überarbeitung der betreffenden Schaltung gemäß Spezifikation
oder
- Verwendung von Schaltungen, die für den ungünstigsten Fall (worst-case) ausgelegt sind.

Da ein neuer Schaltungsentwurf bei Generatorprogrammen nicht realisierbar ist, wird die Verwendung von Schaltungen, die für den ungünstigen Fall ausgelegt sind, mit allen damit verbundenen Nachteilen in Kauf genommen, zumal eine Neuentwicklung oder Überarbeitung der Schaltungen nicht realisierbar ist.

Der vorliegenden Erfindung liegt daher die Aufgabe zugrunde, ein Verfahren der eingangs genannten Art zu schaffen, durch das die erläuterten Nachteile der herkömmlichen Vorgehensweisen beseitigt werden.

Zur Lösung dieser Aufgabe wird ein Verfahren der eingangs genanten Art und gemäß dem Oberbegriff des Patentanspruchs 1 vorgeschlagen, das durch die in dem kennzeichnenden Teil des Patentanspruchs 1 angegebenen Merkmale gekennzeichnet ist.

Vorteilhafte Weiterbildungen der Erfindung sind durch die in den Unteransprüchen angegebenen Merkmale gekennzeichnet.

Im folgenden wird das erfindungsgemäße Vefahren zur Herstellung von vollparametrisierbaren Schaltungen beispielhaft anhand mehrerer Figuren beschrieben.

Fig. 1 zeigt eine übliche Darstellung eines Wortdecoders der sich noch in seinem Originalzustand, d. h. in dem Auslegungszustand für den ungünstigsten Fall (worst case), nämlich für maximal ausgelegte Schaltungselemente, befindet.

Fig. 2 zeigt eine übliche Darstellung eines Beispiels für eine integrierte Schaltungsanordnung - im vorliegenden Fall des Wortdecoders, der z. B. Bestandteil eines RAM ist - aus der verfahrensgemäß die zu parametrisierenden Schaltungselemente "ausgeblendet" wurden.

Fig. 3 zeigt eine übliche Darstellung des Wortdecoders gemäß Fig. 2, in den die parametrisierten Schaltungselemente "eingeblendet" worden sind.

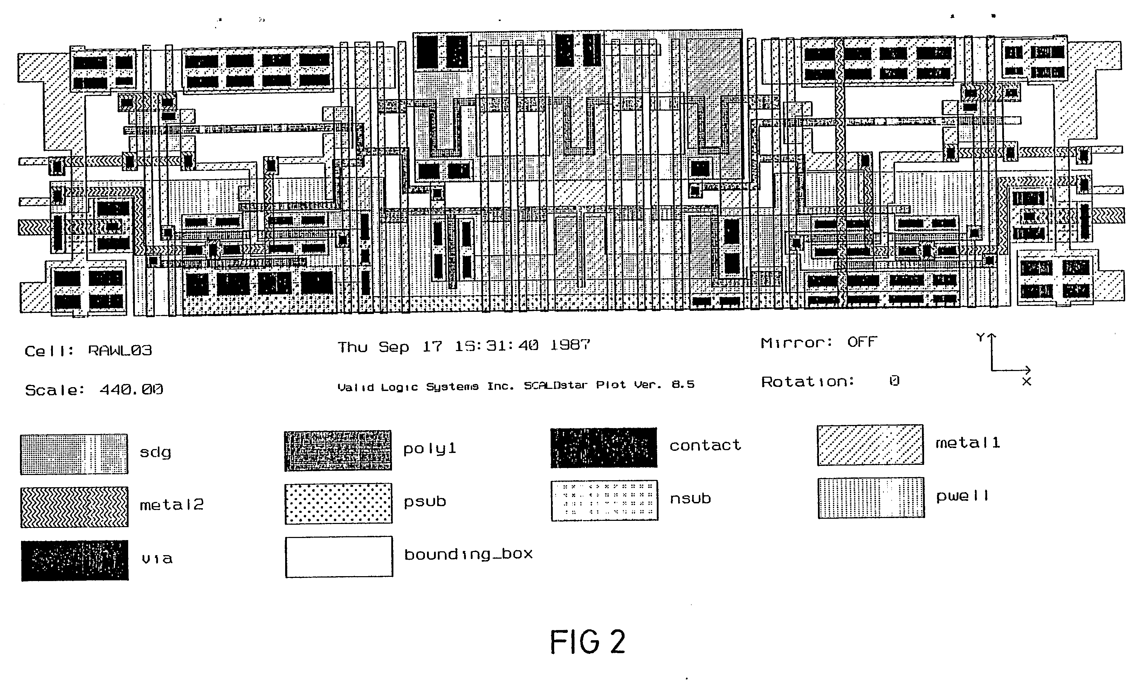

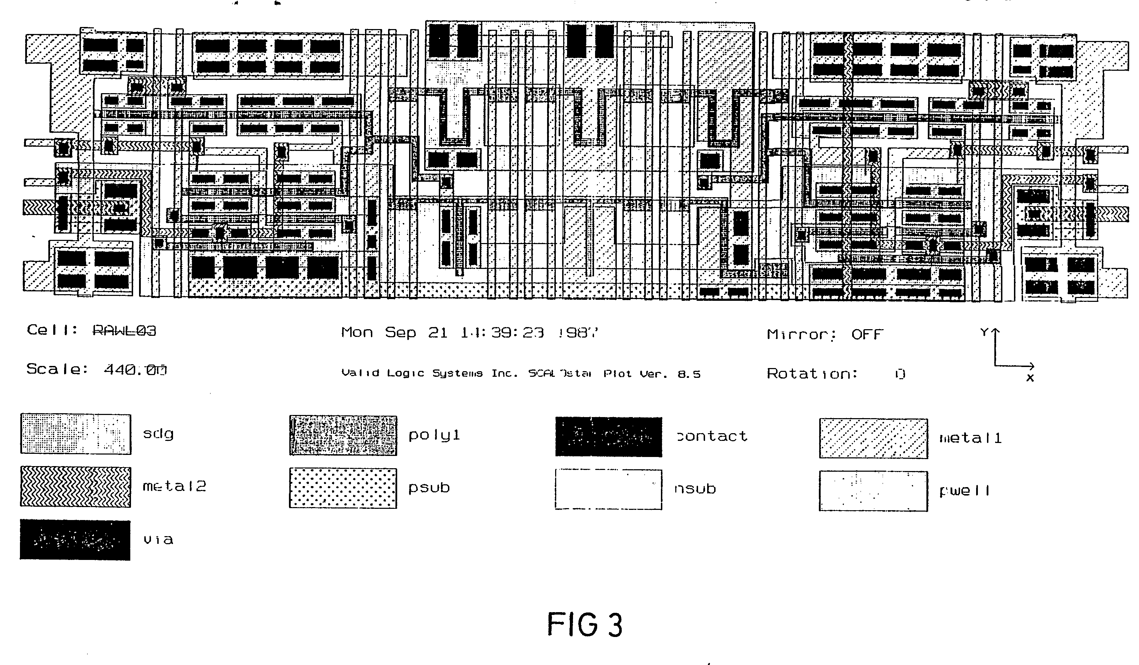

In einem ersten Verfahrensschritt werden die zu parametrisierenden Schaltungselemente, die für den ungünstigsten Fall (worst case) ausgelegt worden sind, aus der Schaltung "ausgeblendet", und die so erhaltene Schaltungsstruktur wird als Schaltungsschablone oder Schaltungsskelett abgespeichert, vergl. Fig. 2. In einem zweiten Verfahrensschritt werden die zu parametrisierenden Schaltungselemente individuell für den jeweiligen Anwendungsfall in geeigneter Weise entworfen und dimensioniert (designing), um anschließend in die Schaltungsschablone "eingeblendet" zu werden, um auf diese Weise eine vollparametrisierte Schaltung zu erhalten, vergl. Fig. 3.

Um beispielsweise erhöhten Anforderungen an ein RAM, das mit Hilfe von Generatorprogrammen erzeugt wird, bezüglich geringer Verlustleistung, schnellerer Zugriffzeit und minimaler Fläche, gerecht zu werden, müssen die Subzellen gemäß den äußeren Belastungen, wie z. B. der kapazitiven Belastung der Wort- oder Bitleitung, in geeigneter Weise angepaßt oder parametrisiert werden. Die Wortdekoderzelle wird dazu für den maximal auftretenden Belastungsfall ausgelegt. Die relevanten Schaltungselemente, wie z. B. Inverterketten, werden erfindungsgemäß wieder aus der Schaltung entfernt ("ausgeblendet"), und die so erhaltene Schaltungsstruktur wird als Schaltungsschablone abgelegt.

Die benötigte Maskeninformation für die Schaltungselemente wird erst zu einem späteren Zeitpunkt der Schaltungsschablone zugefügt (in diese "eingeblendet"). Die Schaltungsschablone genügt den für die Technologie geltenden DRC-Checks. Sind für einen konkreten Anwendungsfall die äußeren Belastungen der Schaltung bekannt, können die Schaltungselemente individuell den tatsächlichen Belastungen bzw. Anforderungen angepaßt werden. Die angepaßten Schaltungselemente werden zusammen mit der Schaltungsschablone als aktuell angepaßte Gesamtschaltung abgelegt und in einem anschließenden Programmablauf zur physikalischen Realisierung verwendet.

Durch "Ausblenden" der für den ungünstigsten Fall (worst case) ausgelegten Schaltungselemente gewährleistet die Schaltungsschablone ein maximales Platzangebot für unterschiedliche Schaltungselement-Strukturen. Durch geeignetes Plazieren der zu parametrisierenden oder anzupassenden Schaltungselemente an den jeweiligen Rändern der Schaltungsschablone kann die nicht benötigte Fläche anderweitig verwendet werden. Dies führt zu einer Reduzierung der gesamten Schaltungsfläche.

In der Anlage ist ein Beispiel für ein Programm zur automatischen Durchführung des erfindungsgemäßen Verfahrens beigefügt.

## Ansprüche

1. Verfahren zur Herstellung vollparametrisierbarer Schaltungen, dadurch **gekennzeichnet**, daß in einem ersten Verfahrensschritt von einer für den ungünstigen Fall (worst case) ausgelegten Schaltung ausgegangen wird (Fig. 1), um die darin zu parametrisierenden Schaltungselemente "auszublenden", wobei die Ausgangsschaltung in Form eines Datenblocks bereitgestellt wird und die "auszublendenden" Schaltungselemente" - vertreten durch entspechende Datensätze - aus dem Datenblock herausgetrennt und zu ihrer Parametrisierung gesondert abgelegt werden, und die so erhaltene Schaltungsstruktur als Schaltungsschablone in geeigneter Weise zwischenzeitlich abgelegt wird, daß in einem zweiten Verfahrensschritt die zu parametrisierenden Schaltungselemente individuell für den jeweiligen Betriebsfall in geeigneter Weise ausgelegt werden, um daran anschließend zusammen mit der Schaltungsschablone als vollparametrisierte Schaltung zusammengesetzt und als neuer Datenblock abgelegt zu werden.

2. Verfahren nach Anspruch 1, dadurch **gekennzeichnet,** daß die Verfahrensschritte von einem Bedienungsplatz oder Rechnerterminal mit Bildschirm und Tastenfeld durch eine qualifizierte Bedienungsperson ausgeführt werden.

3. Verfahren nach Anspruch 1, dadurch **gekennzeichnet,** daß die Verfahrensschritte von einem Bedienungsplatz oder Rechnerterminal mit Bildschrim, Tastenfeld und einem Hilfsmittel zum Arbeiten mit graphischer, menuegesteuerter Bildschirm-Benutzeroberfläche, z. B. einer "Maus", ausgeführt werden.

4. Verfahren nach Anspruch 1, dadurch **gekennzeichnet,** daß die Verfahrensschritte vollautomatisch durch einen Rechner nach Eingabe der Parametrisierungs-Spezifikationsdaten ausgeführt werden.

Cell: RAWL

Scale: 440.00

Mirror: OFF

Rotation:　　0

Y↑
→ x

EP 0 309 926 A2

sdg

poly1

contact

metal1

metal2

psub

nsub

pwell

via

bounding_box

FIG 1

Cell: RAWL03     Thu Sep 17 15:31:40 1987     Mirror: OFF

Scale: 440.00    Valid Logic Systems Inc. SCALDstar Plot Ver. 8.5     Rotation: 0

Legend:
- sdg
- metal2
- via
- poly1
- psub
- bounding_box
- contact
- nsub
- metal1
- pwell

EP 0 309 926 A2

FIG 2

Cell: RAWL03  Mon Sep 21 11:39:23 1987  Mirror: OFF

Scale: 440.00  Valid Logic Systems Inc. SCAL Detal Plot Ver. 8.5  Rotation: 0

sdg    poly1    contact    metal1

metal2    psub    nsub    pwell

via

FIG 3